Europäisches Patentamt

European Patent Office

Office européen des brevets

(11) Numéro de publication: **0 356 696**

**A1**

## (12) DEMANDE DE BREVET EUROPEEN

(21) Numéro de dépôt: 89113557.6

(51) Int. Cl.5: **G01R 15/02**

(22) Date de dépôt: 24.07.89

(30) Priorité: 26.07.88 FR 8810063

(43) Date de publication de la demande:
07.03.90 Bulletin 90/10

(84) Etats contractants désignés:
AT BE CH DE ES FR GB GR IT LI LU NL SE

(71) Demandeur: **GEC ALSTHOM SA**
**38, avenue Kléber**
**F-75116 Paris(FR)**

(72) Inventeur: **Dupraz, Jean-Pierre**
**7, rue Moissonier**
**F-69003 Lyon(FR)**

(74) Mandataire: **Weinmiller, Jürgen et al**
**Lennéstrasse 9 Postfach 24**
**D-8133 Feldafing(DE)**

(54) **Dispositif de mesure des courants de phase d'une installation triphasée.**

(57) L'invention concerne un dispositif de mesure des courants de phase d'une installation triphasée à l'aide de bobines de ROGOWSKI. Chaque bobine (1, 2, 3) est reliée d'une part à un amplificateur opérationnel (10, 20, 30) monté en intégrateur et à un amplificateur inverseur (100, 200, 300) dont la sortie est reliée à l'entrée des amplificateurs intégrateurs des deux autres phases.

Application à la mesure des courants de phase d'une installation blindée.

FIG. 1

EP 0 356 696 A1

## Dispositif de mesure des courants de phase d'une installation triphasée

La présente invention concerne un dispositif de mesure des courants de phase d'une installation triphasée, destiné notamment à équiper des cellules moyenne tension.

La présente invention vise plus particulièrement un dispositif de mesure dans lequel le transducteur utilisé pour convertir le courant de chaque phase en un signal de mesure est une bobine de ROGOWSKI.

On rappelle qu'une bobine de ROGOWSKI est une bobine torique, sans noyau magnétique, entourant le conducteur dont on mesure l'intensité du courant.

On pourra se référer, pour la mesure des courants à l'aide de bobines de ROGOWSKI, au document IEE PROCEEDINGS section A à I volume 130, part B, n° 5 septembre 1988 pages 360 à 363.

La force électro-motrice E induite dans une telle bobine est proportionnelle à la dérivée temporelle du courant I, ce qu'on exprime par la formule valable en première approximation.

$$E = S \frac{\partial I}{\partial t} \quad \text{avec}$$

$$S = N \mu_0 \frac{\Pi}{4} \frac{(D+d)^2}{2 \Pi R} = \frac{1}{8} N \mu_0 \frac{(+d)^2}{R}$$

avec : N nombre de spires de la bobine
$\mu_0$ perméabilité du vide
D diamètre du mandrin de la bobine
d diamètre du fil de la bobine (sur isolant)
R distance du centre du conducteur au centre de la section du tore

On appelle S la sensibilité de la bobine de ROGOWSKI.

Enfin, on rappelle que le schéma électrique équivalent d'une bobine de ROGOWSKI, vu de la charge, est constitué par une source alternative

$E = S \frac{\partial I}{\partial t}$ en série avec une inductance 1 et une résistance r.
avec : $1 = N.S$
et

$$r = 4 \rho \frac{N (D+d)}{d_0^2}$$

avec : do : diamètre du fil, sur métal.
: résistivité du matériau du fil.

Lorsqu'on mesure les intensités des trois phases d'un circuit triphasé, on dispose sur chacun des fils de phase une bobine de ROGOWSKI. Or, dans les applications industrielles comme l'équipement d'une cellule moyenne tension, les trois bobines peuvent être proches les unes des autres. Il en résulte que des influences d'une phase sur l'autre peuvent apparaître, en ce sens qu'un courant important circulant dans une phase peut induire, par couplage magnétique, une force électro-motrice dans les bobines des phases voisines.

Un but de l'invention est d'associer au dispositif de mesure un circuit permettant d'éliminer les effets perturbateurs des couplages mutuels.

Le document DE-A 2 845 155 pose le problème de l'élimination de l'influence mutuelle des bobines, mais il ne décrit pas de moyens pour le résoudre.

L'invention a ainsi pour objet un dispositif de mesure des courants de phase d'une installation triphasée, comprenant sur chacun des conducteurs de phase i, j, k disposés en triangle une bobine de ROGOWSKI, les trois bobines étant identiques, chaque bobine étant reliée à un amplificateur opérationnel dont la sortie fournit un signal proportionnel à la valeur du courant dans la phase considérée, ledit amplificateur étant monté en intégrateur avec une première résistance sur l'entrée négative, une seconde résistance et un condensateur en parallèle, entre entrée négative et sortie, et une troisième résistance entre l'entrée positive et la masse, caractérisé en ce que chaque bobine de ROGOWSKI est reliée à l'entrée d'un amplificateur inverseur, la sortie d'un inverseur associé à une phase i étant reliée aux amplificateurs opérationnels correspondant aux deux autres phases (j, k) par des résistances rij et rik, les résistances rij étant choisies pour vérifier les relations Mij = o, les termes Mij étant les termes non diagonaux de la matrice [M] = [y] [S]

où

$$[s] = \begin{pmatrix} S & m12 & m13 \\ m12 & S & m23 \\ m13 & m23 & S \end{pmatrix}$$

et

$$[y] = \begin{pmatrix} \dfrac{1}{R1} & -\dfrac{1}{r21} & -\dfrac{1}{r31} \\ -\dfrac{1}{r12} & \dfrac{1}{R1} & -\dfrac{1}{r32} \\ -\dfrac{1}{r13} & -\dfrac{1}{r23} & \dfrac{1}{R1} \end{pmatrix}$$

où :

R1 est la valeur de la première résistance

S est la sensibilité d'une bobine de ROGOWSKI vis-à-vis de sa propre phase

mij est la sensibilité d'une bobine de ROGOWSKI placée dans une phase i, vis-à-vis du courant qui passe dans la phase j voisine,

En variante, l'invention concerne un dispositif de mesure des courants de phase d'une installation triphasée, comprenant sur chacun des conducteurs de phase i, j, k, disposés en triangle une bobine de ROGOWSKI, les trois bobines de ROGOWSKI étant identiques, chaque bobine étant reliée à un amplificateur opérationnel dont la sortie fournit un signal proportionnel à la valeur du courant dans la phase considérée, ledit amplificateur étant monté en intégrateur avec une première résistance (R1) sur l'entrée négative, un condensateur (C) en parallèle, entre entrée négative et sortie, une seconde résistance R2 entre l'entrée positive et la masse, la sortie d'une bobine d'une phase i étant reliée en outre aux entrées positives des amplicateurs opérationnels relatifs aux autres phases j et k par des résistance respectivement rij et rik, les résistance rij ayant une ayant une même valeur ρ très supérieure à celle de ladite seconde résistance R'2, le rapport

$$\frac{R'2}{\rho} \quad \text{étant voisin de} \quad \frac{m}{m+S}$$

où

m est la sensibilité d'une bobine ROGOWSKI vis-à-vis du courant qui passe dans la phase voisine,

S est la sensibilité d'une bobine de ROGOWSKI vis-à-vis de sa propre phase.

L'invention est précisée par la description ci-après de deux modes de réalisation de l'invention, en référence au dessin annexé dans lequel:

- la figure 1 représente le schéma électrique d'un dispositif de mesure de courant selon un premier mode de réalisation de l'invention, assurant une compensation parfaite ;

- la figure 2 est un schéma d'une variante de réalisation plus économique, assurant néanmoins une compensation suffisante, si m≪s.

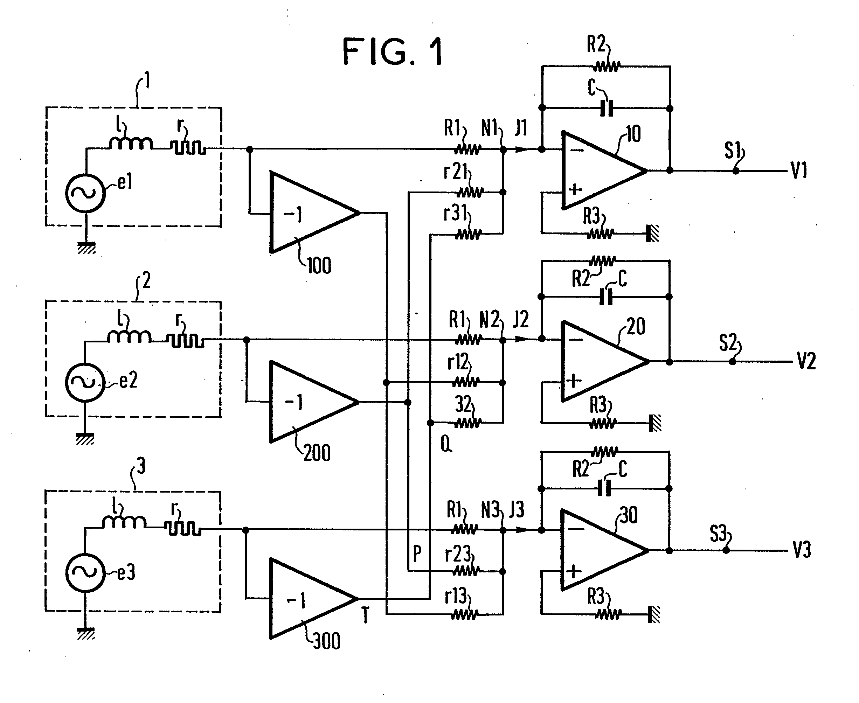

Dans la figure 1, les rectangles référencés, 1, 2 et 3 représentent symboliquement trois bobines de ROGOWSKI, identiques, supposées disposées respectivement sur l'une des phases d'une installation triphasée, dont les courants à mesurer sont désignés par I1, I2 et I3.

A l'intérieur des rectangles, les bobines sont schématisées par leur circuit électrique équivalent e, l, r, comme il a été indiqué plus haut.

Chacune des bobines est associée à un amplificateur opérationnel (respectivement 10, 20 et 30) par l'intermédiaire d'une résistance de valeur R1 sur la borne d'entrée négative.

En parallèle sur chaque amplificateur opérationnel sont placés une résistance de valeur R2 et un condensateur de capacité C.

Enfin, la borne d'entrée positive de chaque amplificateur opérationnel est mis à la masse par une résistance de valeur R3.

La sortie de la bobine 1 est relié à un amplificateur 100, du type inverseur ayant une grande impédance d'entrée et de gain égal à -1.

La sortie de l'amplificateur 100 est reliée à travers une résistance r12 à l'entrée négative de l'amplificateur opérationnel 20 et par une résistance r13 à l'entrée négative de l'amplificateur opérationnel 30.

De la même façon, la sortie de la bobine 2 est reliée à un inverseur 200 dont la sortie est connectée à l'amplicateur opérationnel 10, par une résistance r21 et à l'amplificateur opérationnel 30 par une résistance r23.

Enfin, la sortie de la bobine 3 est reliée à un inverseur 300 dont la sortie est connectée à l'amplificateur opérationnel 10 par une résistance r31 et à l'amplificateur opérationnel 20 par une résistance 232.

On désigne respectivement par V1, V2, V3 les tensions aux sorties S1, S2, S3 des amplificateurs opérationnels.

On va montrer que dans certaines hypothèses de choix des valeurs des diverses résistances du circuit, et si les bobines de ROGOWSKI sont identiques, l'influence mutuelle des bobines est annulée et les signaux V1, V2 et V3 sont respectivement proportionnels aux courants de phases I1, I2 et I3.

On désigne par J1, J2 et J3 les valeurs des courants aux noeuds N1, N2 et N3 que constituent les groupes de 3 résistances reliées à l'entrée négative des amplificateurs opérationnels.

- Les tensions à vide aux bornes des bobines de ROGOWSKI sont données par

e1 = $Spl_1$, + m12pl2 + M13pl3

e2 = m12pl1 + S.p.l2 + m23pl3

e3 = m13pl1 + m23pl2 + Spl3

S : sensibilité des bobines de ROGOWSKI

p : opérateur de Laplace : (dérivée par multiplication par p)

ei : tensions (en notation complexe)

li : courants (en notation complexe)

mij = mji : sensibilité de la bobine placée sur la phase i vis à vis du courant circulant dans la phase j.

- Les courants J1, J2, J3 sont donnés par

$$J1 = \frac{1}{R1} e1 - \frac{1}{r21} e2 - \frac{1}{r31} e3$$

$$J2 = -\frac{1}{r12} e1 + \frac{1}{R1} e2 - \frac{1}{r32} e3$$

$$J3 = -\frac{1}{r13} e1 - \frac{1}{r23} e2 - \frac{1}{R1} e3$$

On a fait l'hypothèse que les capteurs sont identiques (R1 est identique pour les trois phases) et que R1 et très grand devant r, ce qui permet de négliger la chute de tension dans l'impédance interne des capteurs.

On peut écrire ces relations sous forme matricielle.

$$[e] = [s] \cdot [\dot{I} \cdot] \quad p$$

$$[J] = [y][e] = [y] \cdot [s] \cdot [I] \cdot \quad p$$

$$[e] = \begin{pmatrix} e1 \\ e2 \\ e3 \end{pmatrix} \qquad [I] = \begin{pmatrix} I1 \\ I2 \\ I3 \end{pmatrix} \qquad [J] = \begin{pmatrix} J1 \\ J2 \\ J3 \end{pmatrix}$$

$$[s] = \begin{pmatrix} S & m12 & m13 \\ m12 & S & m23 \\ m13 & m23 & S \end{pmatrix} \qquad [y] = \begin{pmatrix} \dfrac{1}{R1} & -\dfrac{1}{r21} & -\dfrac{1}{r31} \\ -\dfrac{1}{r12} & \dfrac{1}{R1} & -\dfrac{1}{r32} \\ -\dfrac{1}{r13} & -\dfrac{1}{r23} & \dfrac{1}{R1} \end{pmatrix}$$

Posons $[M] = [y] \cdot [s]$

$$[M] = \begin{pmatrix} M11 & M21 & M31 \\ M12 & M22 & M32 \\ M13 & M23 & M33 \end{pmatrix}$$

Avec

$$M11 = \frac{S}{R1} - \frac{m12}{r21} - \frac{m13}{r31}$$

$$M22 = \frac{S}{R1} - \frac{m12}{r12} - \frac{m23}{r32}$$

$$M33 = \frac{S}{R1} - \frac{m13}{r13} - \frac{m23}{r23}$$

Les résistances r12, r13, r21, r23, r31, r32 sont choisies pour vérifier autant que possible les relations :
M21 = M31 = M12 = M32 = M13 = M23 = 0
Ce qui conduit à la résolution du système d'équations suivant :

$$M21 = \frac{m12}{R1} - \frac{S}{r21} - \frac{m23}{r31} = 0$$

$$M31 = \frac{m13}{R1} - \frac{m23}{r21} - \frac{S}{r31} = 0$$

$$M12 = -\frac{S}{r12} + \frac{m12}{R1} - \frac{m13}{r32} = 0$$

$$M32 = -\frac{m13}{r12} + \frac{m23}{R1} - \frac{S}{r32} = 0$$

$$M13 = -\frac{S}{r13} - \frac{m12}{r23} + \frac{m13}{R1} = 0$$

$$M23 = -\frac{M12}{r13} - \frac{S}{r23} + \frac{m23}{R1} = 0$$

Ce qui conduit aux solutions suivantes :

$$r31 = R1 \frac{S^2 - (m23)^2}{S.m13 - m12.m23}$$

$$r21 = R1 \frac{S^2 - (m23)^2}{S.m12 - m13.m23}$$

$$r32 = R1 \frac{S^2 - (m13)^2}{S.m23 - m12.m13}$$

$$r12 = R1 \frac{S^2 - (m13)^2}{S.m12 - m23.m13}$$

$$r23 = R1 \frac{S^2 - (m12)^2}{S.m23 - m13.m12}$$

$$r13 = R1 \frac{S^2 - (m12)^2}{S.m13 - m23.m12}$$

Alors, les courants J1, J2, J3 ont une valeur donnée par :

$$J1 = M11pI1 = \left( \frac{S}{R1} - \frac{m12}{r21} - \frac{m13}{r31} \right) pI1,$$

$$J2 = M22pI2 = \left( \frac{S}{R1} - \frac{m12}{r12} - \frac{m23}{r32} \right) pI2,$$

$$J3 = M33pI3 = \left( \frac{S}{R1} - \frac{m13}{r13} - \frac{m23}{r23} \right) pI3,$$

L'influence de phases voisines est totalement neutralisée. Les tensions de sortie s'obtiennent, en négligent R2, par une simple intégration, car :

$$V_1 = \frac{R2}{1 + R2Cp} \quad J1 = \frac{1}{Cp} \cdot I1 \cdot \frac{R2Cp}{R2Cp + 1}$$

si $R2Cp \gg 1$, alors $V1 \# \frac{1}{Cp} J_1$
D'où les relations

$$V1 = \frac{M11}{C} I1 \ H(p)$$

$$V2 = \frac{M22}{C} I2 \ H(p)$$

$$V3 = \frac{M33}{C} I2 \ H(p)$$

$$\text{avec } H(p) = \frac{R2Cp}{R2Cp + 1} \not{=} 1 \text{ si } R2Cp \gg 1$$

Le couplage parasite est bien neutralisé.

Le mode de réalisation qui vient d'être décrit nécessite l'emploi de trois amplificateurs inverseurs.

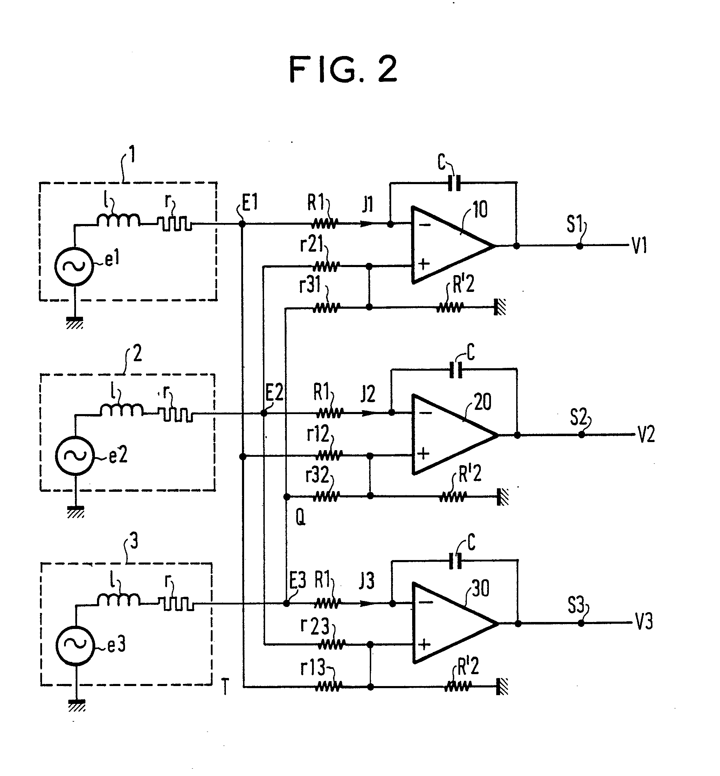

Une variante plus économique est décrite en référence à la figure 2. Elle fournit une compensation suffisante lorsque le couplage entre phases voisines et capteurs est faible.

Les éléments communs aux figures 1 et 2 ont reçu les mêmes numéros de référence.

On retrouve les bobines de ROGOWSKI 1, 2 et 3, les amplificateurs opérationnels 10, 20 et 30, leur résistance d'entrée R1, mais avec seulement une capacité C parallèle.

La sortie de la bobine 1 est reliée par une résistance r12 à l'entrée positive. de l'amplificateur opérationnel 20 et par une résistance r13 à l'entrée positive de l'amplificateur opérationnel 30. De même, la sortie de la bobine 2 est reliée par une résistance r21 à l'entrée positive de l'amplicateur opérationnel 10 et par une résistance r23 à l'entrée positive de l'amplicateur opérationnel 30.

Enfin, la sortie de la bobine 3 est reliée par une résistance r31 à l'entrée positive de l'amplificateur opérationnel 10 et par une résistance r32 à l'entrée positive de l'amplicateur opérationnel 20.

Dans le cas où les phases sont symétriques et les bobines identiques, on a $m12 = m13 = m23 = m$.

On va montrer pour la phase 1 seulement, que la compensation est effective.

Si on désigne par $\rho$ la valeur commune de r12, r13, r21, r23, r31 et r32, et par V+ et V- les tensions d'entrée de l'amplificateur opérationnel 10, il vient

$$V+ = \frac{\rho \frac{R'2}{\rho + R'2}}{\frac{\rho R'2}{\rho + R'2} + \rho} (E2 + E3)$$

où E2 et E3 désignent les tensions à la sortie des bobines de ROGOWSKI. Par hypothèse nous sommes dans le cas d'un couplage faible : m/s très inférieur à 1)

Si on prend $\rho$ très supérieur à $R'2$ il vient

$$V+ = \frac{R'2}{\rho} (E2 + E3)$$

$$\text{d'où } J1 = \frac{E1 - V+}{R1} = Cp(V+ - V1)$$

d'où il vient :

$$V1 = -\frac{1}{R1Cp} \; E1 \; + \; \frac{1 + R1Cp}{R1Cp} \; V+$$

$$= -\frac{1}{R1Cp} \; E1 \; + \; \frac{R'2}{\rho} \; \frac{1 + R1Cp}{R1Cp} \, (E2 + E3)$$

mais :
$E1 = SpI1 + mp \,(I2 + I3)$
$E2 = SpI2 = mp \,(I1 + I3)$
$E3 = SpI3 = mp \,(I1 + I2)$

$$R1CpV1 = -SpI1-mp\,(I2+I3) \; + \; \frac{R'2}{\rho} \,(1+R1Cp) \left[ Sp\,(I2+I3) + mp\,(2I1+I2+I3) \right]$$

$$R1CpV1 = -\left[ S-2m\,\frac{R'2}{\rho}\,(1+R1Cp) \right] I1 \; + \; \left[ \frac{R'2}{\rho}\,(1+R1Cp)\,(S+m) - m \right] (I2+I3)$$

Dans la pratique, $R1Cp = R1C\omega \ll 1$
(exemple : $R1C\omega = 0,01$)
Si l'on choisit $\rho$ tel que

$$\frac{R'2}{\rho} \,(1+R1Cp)\,(S+m)-m \; = \; 0$$

C'est-à-dire :

$$\frac{R'2}{\rho} \; \neq \; \frac{m}{m+s} \; ,$$

(en négligeant R1Cp) Alors, il vient

$$V_1 = -\frac{S}{R1C} \left[ 1-2m\,\frac{R'2}{\rho}\,(1+R1Cp) \right] I_1$$

Puisque nous négligeons R1Cp devant 1, il vient

$$V1 = -\frac{S}{R1C} \left[ 1-2\,m\,\frac{R'2}{\rho} \right]$$

L'influence des phases voisines est éliminée.
Il convient de rappeler les hypothèses qui autorisent l'emploi de ce schéma :
- faible couplage parasite : $\frac{m}{s} \ll 1$
- gain de l'intégrateur élevé : $R1Cp \ll 1$
Le compensation, bien qu'imparfaite, est suffisante dans beaucoup de cas mais le montage est bien plus économique que celui de la figure 2.

**Revendications**

1/ Dispositif de mesure des courants de phase d'une installation triphasée, comprenant sur chacun des conducteurs de phase (i, j, k) une bobine de ROGOWSKI, les trois bobines de ROGOWSKI étant identiques, chaque bobine étant reliée à un amplificateur opérationnel dont la sortie fournit un signal proportionnel à la valeur du courant dans la phase considérée, ledit amplificateur étant monté en intégrateur avec une première résistance (R1) sur l'entrée négative, une seconde résistance (R2) et un condensateur (C) en parallèle, entre entrée négative et sortie, une troisième résistance (R3) entre l'entrée positive et la masse, caractérisé en ce que chaque bobine de ROGOWSKI (1, 2, 3) est reliée à l'entrée d'un amplificateur inverseur (100, 200, 300), la sortie d'un inverseur (100) associé à une phase i étant reliée aux amplificateurs opérationnels (20, 30) correspondant aux deux autre phases (j, k) par des résistances rij et rik, les résistance rij étant choisies pour vérifier les relations mij = o, les termes Mij étant les termes non diagonaux de la matrice [M] = [y] (S)
où

$$[s] = \begin{pmatrix} S & m12 & m13 \\ m12 & S & m23 \\ m13 & m23 & S \end{pmatrix}$$

et

$$y = \begin{pmatrix} \dfrac{1}{R1} & \dfrac{1}{r21} & \dfrac{1}{r31} \\ \dfrac{1}{r12} & \dfrac{1}{R1} & \dfrac{1}{r32} \\ \dfrac{1}{r13} & \dfrac{1}{r23} & \dfrac{1}{R1} \end{pmatrix}$$

avec :
R1 est la valeur de la première résistance
S est la sensibilité d'une bobine de ROGOWSKI vis-à-vis de sa propre phase
mij est la sensibilité d'une bobine de ROGOWSKI placée dans une phase i, vis-à-vis du courant qui passe dans la phase j voisine,

2/ Dispositif de mesure des courants de phase d'une installation triphasée, comprenant sur chacun des conducteurs de phase i, j, k, disposés en triangle une bobine de ROGOWSKI, les trois bobines de ROGOWSKI étant identiques, chaque bobine étant reliée à un amplificateur opérationnel dont la sortie fournit un signal proportionnel à la valeur du courant dans la phase considérée, ledit amplificateur étant monté en intégrateur avec une première résistance (R1) sur l'entrée négative, un condensateur (C) en parallèle, entre entrée négative et sortie, une seconde résistance (R2) entre l'entrée positive et la masse, la sortie d'une bobine d'une phase i étant reliée en outre aux entrées positives des amplicateurs opérationnels relatifs aux autres phases j et k par des résistance respectivement rij et rik, les résistance rij ayant une ayant une même valeur $\rho$ très supérieure à celle de ladite seconde résistance R'2, le rapport

$$\frac{R'2}{\rho} \text{ étant voisin de } \frac{m}{m+S}$$

où
m est la sensibilité d'une bobine ROGOWSKI vis-à-vis du courant qui passe dans la phase voisine,
S est la sensibilité d'une bobine de ROGOWSKI vis-à-vis de sa propre phase.

FIG. 1

# F I G. 2

**Office européen des brevets**

**RAPPORT DE RECHERCHE EUROPEENNE**

Numero de la demande

EP   89 11 3557

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | DE-A-2 845 155  (SIEMENS AG) <br> * en entier * <br> --- | 1,2 | G 01 R   15/02 |
| Y | IEE PROCEEDINGS SECTIONS A A I vol. 130, no. 5, part B, septembre 1983, pages 360-363, Old Woking, Surrey, GB; J.A.J. PETTINGA et al.: "A polyphase 500 KA current measuring system with Rogowski coils" * pages 360-363 * <br> --- | 1,2 | |
| A | DE-A-2 656 817  (SIEMENS AG) <br> * page 3, ligne 1 - page 5, ligne 21 * <br> ----- | | |

| | |
|---|---|
| | DOMAINES TECHNIQUES RECHERCHES (Int. Cl.5) |
| | G 01 R   15/00 |

Le présent rapport a été établi pour toutes les revendications

| Lieu de la recherche | Date d'achèvement de la recherche | Examinateur |
|---|---|---|
| BERLIN | 03-11-1989 | LEMMERICH J |